(19) Europäisches Patentamt
European Patent Office
Office européen des brevets

(11) **EP 2 160 765 B1**

(12) **EUROPEAN PATENT SPECIFICATION**

(45) Date of publication and mention
of the grant of the patent:
**14.08.2019 Bulletin 2019/33**

(51) Int Cl.:
**H01L 31/0224** (2006.01)    **H01L 33/00** (2010.01)

(21) Application number: **08826766.1**

(22) Date of filing: **18.04.2008**

(86) International application number:
**PCT/US2008/060938**

(87) International publication number:
**WO 2009/017852 (05.02.2009 Gazette 2009/06)**

(54) **HIGH CONTRAST TRANSPARENT CONDUCTORS AND METHOD OF FORMING THE SAME**

TRANSPARENTE LEITER MIT HOHEM KONTRAST UND VERFAHREN ZU IHRER HERSTELLUNG

CONDUCTEURS TRANSPARENTS DE CONTRASTE ÉLEVÉ ET PROCÉDÉS DE FORMATION DE CEUX-CI

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **20.04.2007 US 913231 P**
**09.10.2007 US 978635 P**
**26.02.2008 US 31643 P**

(43) Date of publication of application:
**10.03.2010 Bulletin 2010/10**

(73) Proprietor: **Cambrios Film Solutions Corporation Road Town, Tortola (VG)**

(72) Inventors:
 • **HEIDECKER, Manfred**
   **Mountain View, CA 94040 (US)**
 • **ALLEMAND, Pierre-Marc**
   **San Jose, CA 95110 (US)**
 • **SPAID, Michael A.**
   **Mountain View, CA 94041 (US)**
 • **DAI, Haixia**
   **San Jose, CA 95129 (US)**

(74) Representative: **Goddar, Heinz J. et al**
**Boehmert & Boehmert**
**Anwaltspartnerschaft mbB**
**Pettenkoferstrasse 22**
**80336 München (DE)**

(56) References cited:
WO-A2-03/060941        WO-A2-2006/073420
WO-A2-2007/022226      US-A1- 2002 172 639
US-A1- 2004 175 844    US-A1- 2005 056 118
US-A1- 2006 008 942    US-A1- 2006 257 638
US-A1- 2006 262 260    US-A1- 2007 077 429

**Description**

BACKGROUND

Technical Field

This disclosure is related to high contrast transparent conductors suitable as functional films in display systems, in particular, to transparent conductors based on conductive nanostructures, and methods of forming the same.

Description of the Related Art

Conductive nanostructures can form optically transparent conductive films due to their submicron dimensions. These conductive films, also referred to as "transparent conductors", have versatile applications as color filters, thin film transistors, polarizers, transparent electrodes and the like.

Copending U.S. Patent Application No. 11/504,822 describes transparent conductors based on conductive nanostructures, in particular, metallic nanowires.

Copending U.S. Patent Application No. 11/871,767 describes devices and displays featuring nanowire-based transparent conductors, which provide both optical transparency and electrical conductivity.

Copending U.S. Patent Application No. 11/871,721 describes functional films (*e.g.*, polarizers) based on highly aligned nanowires. These co-pending applications are incorporated herein by reference in their entireties.

As described in the above copending U.S. patent applications, nanostructure-based transparent conductors are capable of replacing conventional indium tin oxide (ITO)-based transparent conductive films. Like ITO films, nanostructure -based transparent conductors are particularly useful as functional films in electrochromic displays such as flat panel displays and touch screens.

Several optical and electrical parameters of a transparent conductor are typically evaluated for proper function in a display system. These parameters include, for example, optical transparency, resistivity and contrast ratio. Among these, contrast ratio is closely related to image qualities produced by the display system.

Contrast ratio of a display system refers to the ratio of the brightest white to the darkest black that the display system can produce. Typically, a higher contrast ratio is associated with superior image qualities such as clarity and brightness. Conversely, an inadequate contrast ratio manifests itself in de-saturated color, lack of true black, loss of subtle details and so forth.

Contrast ratio is a particularly important attribute in a flat panel display. Unlike conventional cathode ray tube displays, in which light is produced at the front of the display through excitation of phosphorus by electron beams, flat panel displays are typically backlit such that light must travel through multiple optical and electronic elements before emerging from the display. Moreover, flat panel displays such as liquid crystal displays (LCD) require modulating polarized light to control the light transmittance at each pixel. Light depolarization, *i.e.,* the conversion of polarized light into unpolarized light, is thus predominant factor that contributes to lowering the overall contrast ratio and brightness of the display.

When used as functional films such as polarizers, coatings on color filters, and transparent electrodes in a flat panel display, there is a concern that nanostructures -based transparent conductors may cause light depolarization and lower contrast ratio due to the presence of the particulate conductive medium. Factors that may influence depolarization and contrast ratio include, for example, particle shapes and sizes, inter-particle reflections, and light scattering. Thus, there is a need to reduce or eliminate depolarization caused by nanostructures in a nanostructure-based transparent conductor in order to enhance its contrast ratio.

WO 2007/0222682 discloses a transparent conductor including a conductive layer coated on a substrate. The conductive layer comprises a network of nanowires, in particular silver nanowires, which are embedded in a matrix. The conductive layer is optically transparent and flexible. It can be coated or laminated onto a variety of substrates, including flexible and rigid substrates.

US 2006 257 638 discloses an anti-electrostatic resin plate made of a thermoplastic resin, and a transparent and conductive layer comprising carbon nanotubes and formed on at least one face of the substrate. While carbon nanotubes are regarded as the preferred type of conductive fibers for forming the conductive layer, it is mentioned that instead of carbon nanotubes, carbon nanohorn, carbon nanowire, carbon nanofiber, graphite fibril or metal nanotubes may be used.

US 2005/0056118 A1 discloses a method for forming hollow nanostructures by reacting a solution of solid nanostructures comprising one of a first metal and a first metal alloy with a metal salt that can be reduced by the first metal or first metal alloy. The first metal may be silver, used as a sacrificial template, and the metal salt can be $HAuCl_4$. Hollow nanostructures are suggested for use as a catalyst for Suzuki coupling reactions.

BRIEF SUMMARY

Metal nanostructure-based ransparent conductors of high contrast ratio *(e.g.*, higher than 1000) are described. Also described are processes of enhancing contrast ratio of conductive films based on conductive nanostructures, including nanowires and nanotubes.

One embodiment describes a transparent conductor according to claim 1.

A further embodiment describes a process according to claim 10.

BRIEF DESCRIPTION OF THE SEVERAL VIEWS OF THE DRAWINGS

In the drawings, identical reference numbers identify similar elements or acts. The sizes and relative positions of elements in the drawings are not necessarily drawn to scale. For example, the shapes of various elements and angles are not drawn to scale, and some of these elements are arbitrarily enlarged and positioned to improve drawing legibility. Further, the particular shapes of the elements as drawn are not intended to convey any information regarding the actual shape of the particular elements, and have been selected solely for ease of recognition in the drawings.

Figures 1A and 1B show schematically a system for evaluating the contrast ratio of a transparent conductor sample positioned between a pair of polarizers.

Figure 2 shows schematically an embodiment in which nanowires are plated followed by etching.

Figure 3A shows a process for preparing a conducting film composed of nanotubes in the order of first forming a film based on template nanowires followed by plating and etching.

Figure 3B shows a process for preparing a conducting film composed of nanotubes in the order of first plating template nanowires followed by film formation and etching.

Figure 3C shows a process for preparing a conducting film composed of nanotubes in the order of first plating template nanowires followed by etching and film formation according to the invention.

Figure 4 shows schematically an embodiment in which nanowires are plated followed by oxidation or blackening.

Figure 5 shows schematically light polarization when transmitting through highly aligned nanowires.

Figure 6A and 6B show schematically a system for evaluating the contrast ratio of a transparent conductor having highly aligned nanowires.

Figure 7 shows an efficient network of nanowires in which nanowires are aligned orthogonally.

Figure 8 shows an embodiment in which nanowires are plated with a metal followed by plating with a conductive polymer.

Figure 9 shows a system and its geometry for evaluating contrast ratio in a transparent conductor sample.

Figure 10 shows a system for direct visual evaluation of contrast ratio in a transparent conductor sample.

DETAILED DESCRIPTION OF THE INVENTION

Contrast Ratio

As used herein, contrast ratio is defined as the ratio of light transmission ($T_p$) through two polarizers having parallel transmission axes to the light transmission ($T_v$) through two polarizers having vertical (*i.e.,* perpendicular) transmission axes:

$$\text{Contrast Ratio} = T_p / T_v \qquad \text{Formula (I)}$$

Contrast ratio is thus dependent on the efficiency of the crossed polarizers. In the absence of depolarization, contrast ratio measured by a perfect set of crossed polarizers can theoretically reach infinity. In reality, however, light depolarization caused by scattering and reflection can result in a lowered contrast ratio.

Depolarization typically occurs as a consequence of light propagation, reflection, scattering or diffraction. Imperfect polarizers and any intermediate optical elements positioned between the polarizers can contribute to depolarization and reduce the contrast ratio measured according to Formula (I).

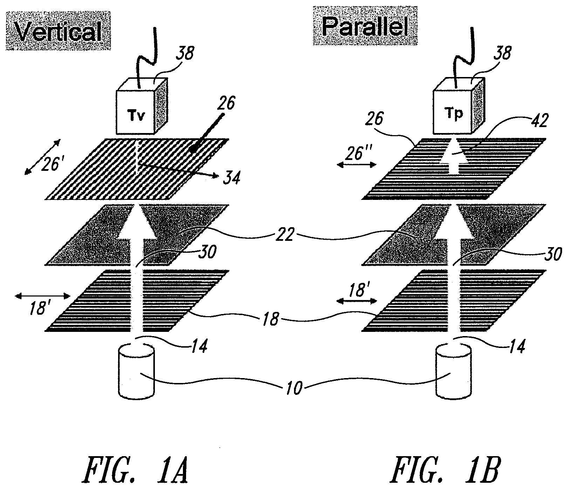

Figures 1A and 1B schematically show a system for evaluating the contrast ratio of a transparent conductor sample as light travels through the transparent conductor sample positioned between a pair of polarizers.

Figure 1A shows the measurement of $T_v$. As shown, light source 10 emits unpolarized light 14, which successively travels through a first polarizer 18, a transparent conductor sample 22 and a second polarizer 26. The first polarizer 18 and the second polarizer 26 are positioned such that their transmission axes (18' and 26', respectively) are perpendicular to each other.

The unpolarized light 14 travels through the first polarizer 18 and emerges as polarized light 30, which is polarized along the transmission axis 18'. This polarized light 30 continues to travel through the transparent conductor sample 22 and the second polarizer 26. Light 34 emerges from the second polarizer 26 and is polarized along the transmission axis 26'. The polarized light 34 can be detected by detector 38, which produces a value of transmission ($T_v$).

In the absence of any depolarization, the second polarizer 26, which has a transmission axis 26' vertical to the polarization direction of the polarized light 30, would have fully blocked the polarized light 30 and no light will be detected by the detector 38 (*i.e.,* $T_v$ is zero). However, any depolarization by the transparent conductor sample 22 may convert a portion of the polarized light 30 into unpolarized light. The unpolarized light has a component that is polarized along the transmission axis 26' of the second polarizer 26, which can be detected after it passes through the second polarizer 26 and emerges as the polarized light 34.

Figure 1B shows the measurement of $T_p$. In a set-up similar to that in Figure 1A, except that the second polarizer 26 is positioned so that its transmission axis 26" is parallel to the transmission axis 18' of the first polarizer 18, unpolarized light 14 from light source 10 is converted to polarized light 30 by the first polarizer 14. The polarized light 30 travels through the transparent conductor sample 22 and the second polarizer 26. Emerging light 42 is polarized along the transmission direction 26", which is parallel to the transmission direction 14'. Detector 30 measures the light transmission ($T_p$) of polarized light 42.

In the absence of any depolarization, polarized light 42 would have had the same intensity as polarized light 30. However, any depolarization by the transparent conductor sample 22 may convert a portion of the polarized light 30 into unpolarized light. This unpolarized light has a component that is perpendicular to the transmission axis 26" of the second polarizer 26, which will be blocked by the second polarizer 26. Accordingly, the light intensity ($T_p$) of emerging light 42 is reduced relative to that of the polarized light 30 due to depolarization.

In the context of a display system such as liquid crystal displays, the contrast ratio is directly related to image quality produced. As known, a reflective LCD contains a liquid crystal imager (*e.g.,* an array of liquid crystal cells) that dynamically creates pixels of varying light intensities. During operation, when a voltage or signal is applied to an individual pixel, the liquid crystal imager is activated and reflects incident light while simultaneously rotating the polarization direction of the light by 90°. This is considered an "on" state. If the liquid crystal imager is not activated, then those particular pixels of the liquid crystal imager are in the "off" state, and the light which is reflected from them will have no rotation of the polarization state. Thus, by modulating polarized light, the liquid crystal imager controls signal or image information. The signals from the "on" pixels should correspond to bright spots in the final image. The signals from the "off" pixels should correspond to dark spots in the final image. Contrast ratio is thus a measure of image quality in such a system and is the ratio of the light transmitted through the system in the "on" state (analogous to $T_p$) divided by that in the "off" state (analogous to $T_v$).

Enhancing Contrast Ratio through Reduction of Light Scattering and Reflectivity

Co-pending U.S. Patent Application Nos. 11/504,822, 11/871,767 and 11/871,721 describe, in certain embodiments, metallic nanowire-based transparent conductors. The metallic nanowires (*e.g.*, silver nanowires) form a conductive network that can achieve higher than 80% light transmission and surface or in-plane resistivity of about 10-1000 ohms/square (or "$\Omega/\square$"). The silver nanowire-based network is therefore a suitable candidate for a functional film (*e.g.,* a transparent electrode or a coating on a color filter) in an optical path of a display system. Silver nanowires are reflective particles. At a loading level requisite for a particular function (*e.g.*, surface conductivity), there may be a sufficient number of silver nanowires to cause depolarization of an impinging polarized light due to reflection and scattering.

As demonstrated, depolarization can cause a decrease in $T_p$ and/or an increase in $T_v$, which in turn lowers the contrast ratio according to Formula (1). Conversely, increasing $T_p$ and/or reducing $T_v$ will enhance the contrast ratio. It is noteworthy that, because $T_v$ is the denominator of Formula (1), a small reduction in $T_v$ can have a profound impact on the contrast ratio. Accordingly, although increasing the power of the light source (*i.e.,* increasing the intensity of unpolarized light 14 in Figures 1A and 1B) can potentially bring forth higher brightness and higher contrast ratio due to

an increased $T_p$, decreasing $T_v$ by a similar degree can more dramatically improve the contrast ratio. Accordingly, reducing depolarization to decrease $T_v$ is highly effective in enhancing contrast ratio. Thus, methods of enhancing contrast ratio of a transparent conductor through reducing depolarization and light scattering are described. Also described are transparent conductors produced according to these methods.

The amount of light scattering off a nanostructure has been associated with its dimensions. Typically, the smaller the dimension, the less light is scattered from the surface of the nanostructure. It has been theoretically demonstrated that light scattering from nanotubes are reduced non-linearly as the wall thickness decreases. Zhu J., Material Science and Engineering A 454-455 (2007).

Thus, one embodiment provides a process for preparing a conducting film composed of hollow nanostructures, the process comprising: forming template nanostructures of a first type of metallic material, depositing the template nanostructures on a substrate to form a template network, plating each of the template nanostructure in the template network with a plating metal of a second type of metallic material, etching the template nanostructures to form hollow nanostructures of the plating metal, wherein the hollow nanostructures form a conductive network.

As used herein, "nanostructures" or "conductive nanostructures" refer to nano-sized structures, at least one dimension of which is less than 500nm, more preferably, less than 250nm, 100nm, 50nm or 25nm. The nanostructures can be formed of any conductive material, including metal (*e.g.*, transition metals), metal alloys, metal compounds (*e.g.*, metal oxides), conductive polymer, conductive carbon nanotubes and the like. Typically, the nanostructures are made of a metallic material. The metallic material can be an elemental metal or a metal compound (e.g., metal oxide). The metallic material can also be a metal alloy or a bimetallic material, which comprises two or more types of metal.

The nanostructures can be of any shape or geometry. In certain embodiments, the nanostructures are isotropically shaped (*i.e.,* aspect ratio = 1). Typical isotropic nanostructures include nanoparticles. In preferred embodiments, the nanostructures are anisotropically shaped (*i.e.* aspect ratio ≠ 1). As used herein, aspect ratio refers to the ratio between the length and the width (or diameter) of the nanostructure. The anisotropic nanostructure typically has a longitudinal axis along its length. Exemplary anisotropic nanostructures include nanowires and nanotubes, as defined herein.

The nanostructures can be solid or hollow. Solid nanostructures include, for example, nanoparticles and nanowires. "Nanowires" refer to solid anisotropic nanostructures, as defined herein. Typically, the nanowire has an aspect ratio (length:diameter) of greater than 10, preferably greater than 50, and more preferably greater than 100. Typically, the nanowires are more than 500nm, or more than 1μm, or more than 10μm in length.

Hollow nanostructures include, for example, nanotubes. "Nanotubes" refer to hollow anisotropic nanostructures, as defined herein. Typically, the nanotube has an aspect ratio (length:diameter) of greater than 10, preferably greater than 50, and more preferably greater than 100. Typically, the nanotubes are more than 500nm, or more than 1μm, or more than 10μm in length.

As disclosed in co-pending U.S. Patent Application No. 11/504,822, the higher the aspect ratio (length:diameter) of the nanostructures, the fewer nanostructures are needed to form a conductive network. As used herein, a conductive network refers to a system of interconnecting or crossing nanostructures. For purpose of this description, the conductive network has a surface resistivity (or "sheet resistance") of no higher than $10^6$ Ω/□. Preferably, the conductive network has a resistivity of no higher than $10^5$ Ω/□, $10^4$ Ω/□, 3,000 Ω/□, 1,000 Ω/□ and 100 Ω/□ or from 100 Q/□ to 1000 Ω/□ or from 10 Ω/□ to 100 Ω/□. In certain preferred embodiments, the conductive network is formed of anisotropic nanostructures such as nanowires, nanotubes, or a mixture thereof. Typically, the conductive network takes the form of a thin film, also referred to as "conductive film". In various embodiments, the thin films are about 100nm to 200nm thick, or 50nm to 100nm thick, or 150nm to 200nm thick.

Thus, one embodiment provides a transparent conductor according to claim 1. In various embodiments, the contrast ratio can be higher than 750, 3000, or higher than 5000. In other embodiments, the transparent conductor have a surface resistivity of less than 1000 Ω/□, less than 500 Ω/□, less than 100 Ω/□, or is between 50 Ω/□ and 400 Ω/□. In other embodiments, the transparent conductor has a a haze of less than 5%. haze of less than 1%. In further embodiments, the transparent conductor has a a light transmission of greater than 85%, greater than 90% or greater than 95%.

Typically, the nanostructures include hollow nanostructures (*e.g.,* metal nanotubes), metal nanowires or a combination thereof. As described herein, the nanostructures are of certain shapes, dimensions, materials that can cause a reduction of light scattering when compared to silver nanowires.

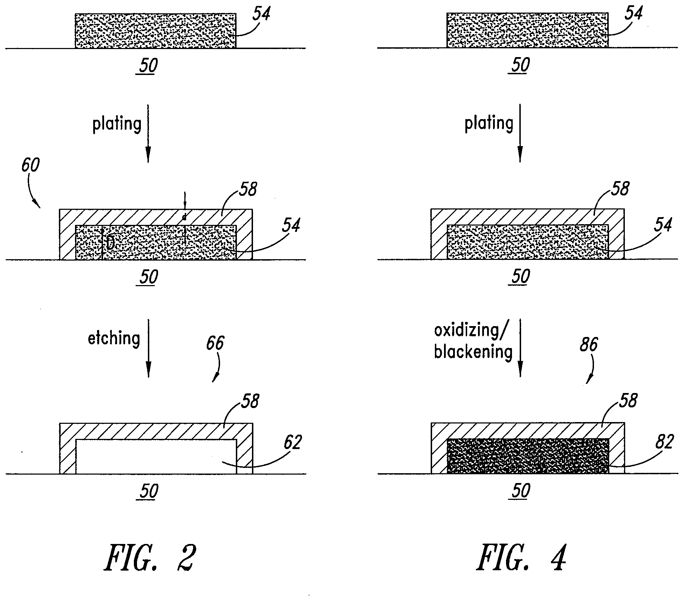

Figure 2 schematically illustrates the process of plating nanostructures followed by etching the nanostructures. Nanowires are shown as representative nanostructures, with the understanding that the process applies to nanostructures of all shapes and structures. For the sake of simplicity and clarity, only one nanowire is shown. On a substrate 50, a nanowire 54 of a first type of metal (*e.g.*, silver) is deposited. Using the nanowire 54 as a template, a thin coating 58 of a metal of a second type (*e.g.*, gold) is plated to form a gold-plated nanowire 60. Thereafter, a selective etching step is carried out to remove the template, *i.e.,* the nanowire 54. The removal of the nanowire template forms a cavity 62 within the coating 120, thus converting the nanowire 54 of the first type of metal to a hollow nanostructure 66, *i.e.,* a nanotube, of the second type of metal.

In certain embodiments, the thickness "d" of the coating 58 on the template nanostructure is less than the diameter "D" of the template nanostructure (Figure 2). The thickness of the coating can be controlled by adjusting the plating time and/or the surface loading density of the template nanostructures. In general, the thickness of the coating can be in the range of 2-30 nm or more typically, in the range of 5-20 nm. In certain preferred embodiments, silver nanowires (30-80 nm in diameters) can be plated with a thin layer of gold of about 10-20 nm thick.

The hollow nanostructure 66 resulting from the etching (Figure 2) has a wall thickness substantially equal to the thickness "d" of the coating. As the coating 58 is thinner than the template nanostructure, less light is scattered from the surface of the hollow nanostructure 66 than it would in the template nanostructure.

Generally speaking, the nanostructures of the first type of metal, also referred to as the "template nanostructures", can be initially prepared according to a desired specification with regard to their dimensions and composition. As discussed in more detail in co-pending U.S. Patent Application No. 11/504,822, the nanostructures can be prepared both chemically and biologically. Currently, chemical synthesis in solution phase can provide nanostructures on commercially relevant scales. When nanowires are used as templates, the "template nanowires" can be synthesized with controllable dimensions. For example, substantially uniform silver nanowires of high aspect ratio (about 100 or higher) can be prepared chemically in a solution phase synthesis at high yield (> 95%). *See,* co-pending U.S. Patent Application No. 11/766,552 to Cambrios Technologies Corporation, the assignee of the present application, which application is incorporated herein by reference in its entirety. Copper, nickel and other metal nanowires can also be used as templates. Typically, the template nanowires are about 1-50$\mu$m long and 20-500nm in diameter.

The template nanostructures are typically formulated into a composition suitable for deposition on a substrate. As used herein, any composition of nanostructures (including, *e.g.*, nanowires, nanotubes, plated nanowires, or a combination thereof) that can be deposited and formed into a film is generally referred to as an "ink composition", "ink dispersion" or "ink". Typically, the ink composition comprises agents that facilitate dispersion of the nanostructures s and/or immobilization of the nanostructures s on the substrates. These agents include surfactants, viscosity modifiers, and the like. Detailed description of formulating the ink compositions can be found in co-pending U.S. Patent Application No. 11/504,822.

The metal to be plated, also referred to as the "plating metal", is selected based on its conductivity, electrochemical potential, reflectivity, chemical stability and so forth. For example, gold can be plated on a template nanostructure (*e.g.*, silver nanowire) to form a gold-coated nanostructure. Etching of the template nanostructure produces gold nanotubes, which as shown herein, can lower light scattering as compared to solid nanostructures. Other suitable metals that can be plated on a template nanostructure include, for example, palladium, nickel, and platinum.

The plating step can be carried out by, for example, electroplating, electro-less plating or metal-metal displacement. During electroplating, the template nanowires initially deposited on the substrate can be used as a working electrode (*i.e.*, a cathode) on which the plating metal can be deposited electrochemically. Typically, the plating metal is in its ionic form in a plating bath, which is in contact with both the template nanowires and a counter electrode (*e.g.*, an anode). When an electrical current is applied, the ions of the plating metal migrate to the cathode and are reduced to elemental metal while being deposited on the surface of the template nanostructures. Alternatively, the plating metal can be a sacrificial electrode, which dissolves into metal ions under the electrical current.

In an electro-less plating, neither electrode nor electrical current is necessary. Instead, a reducing agent is used to convert a plating metal (in ionic form) into its elemental form. For example, the template nanowires can be submerged in a plating solution, which contains a plating metal in its ionic form and a reducing agent. Reducing agents suitable for electro-less plating are known in the art and include, without limitation, formaldehyde, organic boron agents (e.g., sodium borohydride, dimethylaminoborane), and the like. Plating solutions equipped with an appropriate blend of ionic plating metals, suitable reducing agents and stabilizers are also commercially available through vendors such as Stapleton Technologies, Inc. (Long Beach, CA). For example, Stapleton® Micro 291 is a commercial gold plating solution suitable for plating metals such as silver, nickel, copper.

Depending on the relative activities of the metal forming the template nanostructures and the plating metal, direct or spontaneous metal-metal displacement offers yet another plating methodology. In a metal-metal displacement reaction, a more reactive metal can replace an ionic form of a less reactive metal. Thus, if the template nanowires are made of a more reactive metal, when the template nanowires are in contact with ions of a less reactive metal, the less reactive metal will be converted into elemental metal while the more reactive metal is converted to ions. For example, using silver nanowires as templates, a thin layer of gold can be plated on each template nanowire by combining silver nanowires and gold salt including monovalent salt (*e.g.,* ammonium gold sulfite) and trivalent salt (*e.g.*, chloroauric acid). Monovalent gold salts are typically preferred because they replace silver atoms at a 1:1 ratio, whereas a trivalent gold salt replaces three silver atoms per one gold atom. While the silver nanowire erodes (*i.e.*, converting to silver ions), a gold coating is formed on what remains of the silver nanowire. The progress of the displacement reaction is controllable such that the silver nanowires can be partially or fully replaced by gold.

Selective etching removes the template nanostructures of the first type of metal without etching the metal coating of the second type of metal. The etching can be carried out chemically with an etchant. There is no particular limitation as to the etchant so long as it discriminately etches one metal while preserving the other metal. For example, the silver nanowire template can be removed with any silver etchants, including, but are not limited to nitric acid ($HNO_3$), ammonium persulfate (($NH_4$)$_2S_2O_8$), and the like. Optionally, an oxidizing agent can also be present to first convert silver to silver oxide, the latter being further dissolved by nitric acid. An exemplary oxidizing agent is potassium permanganate ($KMnO_4$).

As an alternative to chemical etching, electro-etching can also be used to remove the template nanostructures. During electro-etching, the template nanostructures are made into an anode and in contact with an electrolyte. A counter electrode (*i.e.,* a cathode) is also immersed in the electrolyte. Selective etching is achieved by controlling the voltage applied to the electrodes. The voltage should be higher than the oxidation potential of the first type of metal (for the template nanostructure) and lower than the oxidation potential of the second type of metal (for the plating metal). At such voltage, the template nanostructures can be selectively etched as a sacrificial electrode, while the plated metal remains unaffected. For example, when etching the silver from gold-coated silver nanowires, the voltage applied is typically about 0.8V, which is higher than the electrochemical potential for oxidizing silver, but lower than the electrochemical potential for oxidizing gold. As a result, only the silver nanowires are etched.

It should be recognized that, based on the above description of the various methods of plating and etching, any reasonable combination of plating and etching can be carried out. For example, the template nanostructures can be electroplated and chemically etched, or electroplated and electro-etched, or electro-less plated and electro-etched, and so forth.

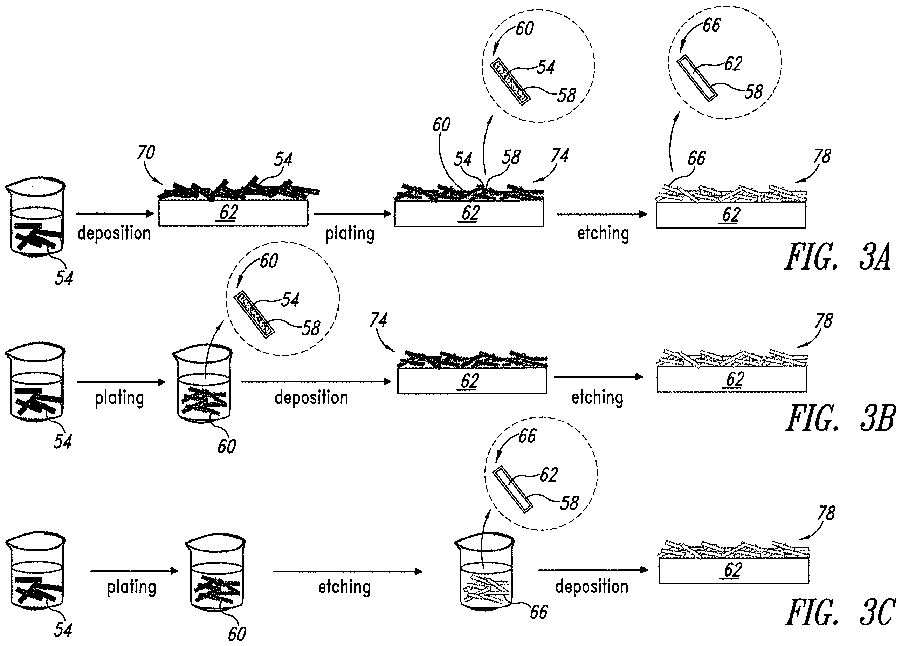

Figure 3A summarizes the above process of forming a conductive film composed of hollow nanostructures, in particular, nanotubes. As shown, template nanowires 54 are initially formed in solution phase, then formulated into an ink and deposited on the substrate 62 and formed into a conductive network, *i.e.*, "template network" 70. By controlling the distribution, orientation and surface loading density of the template nanowires (*i.e.,* the number of nanowires per unit area), the template network 70 can attain specific electrical conductivity and optical transmission, including optical transparency and reflectivity. The template nanowires 54 are then plated with a layer 58 of the second metal to form plated nanowires 60. Thereafter, the template nanowires are removed by etching, and hollow nanostructures (*i.e.,* nanotubes 66) are formed.

Following the plating and etching processes, the template network 70 transforms to a network of the plated nanowires 74 and ultimately into a new conductive film 78 composed of hollow nanostructures of the plating metal. Advantageously, the general distribution, orientation and the loading density set by the template nanostructures are preserved, such that the final conductive network 78 can be formed with substantially unchanged optical transmission. However, because the wall thicknesses of the resulting hollow nanostructures are generally made thinner than the diameters of the template nanostructure, light scatterings can be significantly reduced. As will be shown in the Examples, the contrast ratio of a network formed of nanotubes can be orders of magnitude higher than a network formed of nanowires (*see, e.g.,* Example 6).

Figure 3B shows a process for preparing a conductive film composed of hollow nanostructures by first plating template nanostructures in a solution phase followed by film formation and etching. Accordingly, this process comprises: forming template nanostructures of a first type of metallic material, plating each of the template nanostructure with a plating metal of a second type of metallic material to form plated template nanostructures, depositing the plated template nanostructures on a substrate, etching the template nanostructures to form hollow nanostructures of the plating metal, wherein the hollow nanostructures form a conductive network.

In Figure 3B, nanowires and nanotubes are shown as exemplary nanostructures. As shown, template nanowires 54 are initially formed and plated in solutions. The plated nanowires 60 are formulated into an ink and deposited on the substrate 62 into a conductive film 74. Thereafter, the plated nanowires 60 of the conductive film 74 can be etched to form the final conductive film 78 composed of nanotubes 66. See, also Example 10.

Figure 3C shows an embodiment for preparing a conductive film composed of hollow nanostructures by first forming hollow nanostructures in a solution phase followed by film formation. Accordingly, this process comprises: forming template nanostructures of a first type of metallic material, plating each of the template nanostructure with a plating metal of a second type of metallic material to form plated template nanostructures, etching the template nanostructures to form hollow nanostructures of the plating metal, depositing the hollow nanostructures on a substrate to form a conductive network.

In Figure 3C, nanowires and nanotubes are shown as exemplary nanostructures. As shown, template nanowires 54 are initially plated and etched in solutions through, for example, electro-less plating and chemical etching. See, also Example 11. Ligands that prevent aggregation of the nanostructures can be employed to facilitate uniform plating and etching processes. Such ligands include poly(vinylpyrrolidone), peptides and proteins (e.g., bovine serum albumin), which disperse the nanostructures s in various stages of the plating and etching processes. The hollow nanostructures of the

plating metal can be isolated (e.g., through filtration and removal of any plating solution) before being formulated into an ink composition. The ink composition is then deposited and immobilized on the substrate 62 to form the final conductive network 78, which comprises networking nanotubes 66. According to this embodiment, hollow nanostructures can be prepared to meet certain specifications with regard to their dimensions and geometries. An end user can then customize the ink composition and in turn control the optical and electrical properties of the final film.

The ink dispersion of nanostructures (e.g., hollow nanostructures such as gold nanotubes, or metal nanowires such as silver nanowires or plated silver nanowires) may contain additives and binders to control viscosity, corrosion, adhesion, and nanowire dispersion. Examples of suitable additives and binders include, but are not limited to, carboxy methyl cellulose (CMC), 2-hydroxy ethyl cellulose (HEC), hydroxy propyl methyl cellulose (HPMC), methyl cellulose (MC), poly vinyl alcohol (PVA), tripropylene gylcol (TPG), and xanthan gum (XG), and surfactants such as ethoxylates, alkoxylates, ethylene oxide and propylene oxide and their copolymers, sulfonates, sulfates, disulfonate salts, sulfosuccinates, phosphate esters, and fluorosurfactants (e.g., Zonyl® by DuPont).

In one example, an "ink" includes, by weight, from 0.0025% to 0.1% surfactant (e.g., a preferred range is from 0.0025% to 0.05% for Zonyl® FSO-100), from 0.02% to 4% viscosity modifier (e.g., a preferred range is 0.02% to 0.5% for HPMC), from 94.5% to 99.0% solvent and from 0.05% to 1.4% metal nanostructures (e.g., hollow nanostructures such as gold nanotubes, or metal nanowires such as silver nanowires or plated silver nanowires). Representative examples of suitable surfactants include Zonyl® FSN, Zonyl® FSO, Zonyl® FSH, Zonyl® FFA, Triton (x100, x114, x45), Dynol (604, 607), n-Dodecyl b-D-maltoside and Novek. Examples of suitable viscosity modifiers include hydroxypropyl methyl cellulose (HPMC), methyl cellulose, xanthan gum, polyvinyl alcohol, carboxy methyl cellulose, hydroxy ethyl cellulose. Examples of suitable solvents include water and isopropanol.

If it is desired to change the concentration of the ink dispersion from that disclosed above, the percent of the solvent can be increased or decreased. The relative ratios of the other ingredients, however, can remain the same. In particular, the ratio of the surfactant to the viscosity modifier is preferably in the range of about 80 to about 0.01; the ratio of the viscosity modifier to the metal nanostructures is preferably in the range of about 5 to about 0.000625; and the ratio of the metal nanostructures to the surfactant is preferably in the range of about 560 to about 5. The ratios of components of the dispersion may be modified depending on the substrate and the method of application used. The preferred viscosity range for the nanostructure dispersion is between about 1 and 100 cP.

Depending on the dimensions and loading density of the nanostructures, the conductive network can be optically transparent. Typically, the optical transparence and clarity of the transparent conductor can be quantitatively defined by parameters including light transmission and haze. "Light transmission" refers to the percentage of an incident light transmitted through a medium. The incident light refers to visible light having a wavelength between about 400nm to 700nm. In various embodiments, the light transmission of the transparent conductor is at least 50%, at least 60%, at least 70%, at least 80%, or at least 85%, at least 90%, or at least 95%. Haze is an index of light diffusion. It refers to the percentage of the quantity of light separated from the incident light and scattered during transmission (i.e., transmission haze). Unlike light transmission, which is largely a property of the medium, haze is often a production concern and is typically caused by surface roughness and embedded particles or compositional heterogeneities in the medium. In various embodiments, the haze of the transparent conductor is no more than 10%, no more than 8%, no more than 5% or no more than 1%. Typically, a higher haze value is associated with a lower contrast ratio. In various embodiments, the contrast ratio of the transparent conductor is more than 1,000, more than 2,000, more than 3,000, more than 4,000, or more than 5,000.

The conductive films formed by hollow nanostructures are chemically and thermally stable. As demonstrated in Example 12, the optical and electrical properties of the conductive films were substantially unchanged after prolonged exposure to heat and chemicals. The conductive film is considered stable if its resistivity does not fluctuate by more than 30%, or more than 5%, or more preferably, by more than 1% when the conductive film is exposed to external factors such as heat or chemicals. Thus, certain embodiments provide a transparent conductor film comprising hollow nanostructures wherein the transparent conductor film has higher than 85% light transmission, lower than 1% haze and lower than 1500 $\Omega$/sq resistivity, and wherein the resistivity does not change by more than 1% when exposed to heat or a chemical agent.

As an alternative or in addition to removing the template nanowire as illustrated in Figure 2, also described herein is a process of blackening the template nanowires following a plating step. More specifically, by dulling or blackening the conductive nanostructures through oxidation, reflectivity can be reduced. Thus, the process comprises depositing on a substrate a plurality of template nanostructures of a first type of metallic material to form a conductive network; plating a coating of a second type of metal on each template nanostructures; and oxidizing the template nanostructures of the first type of metal.

Figure 4 schematically illustrates the above process of plating template nanostructures followed by oxidizing the template nanostructures to form composite nanostructures of the first type of metal, its oxide and the second type of metal. Nanowires are shown as representative nanostructures, with the understanding that the process applies to nanostructures of all shapes and structures. For the sake of simplicity and clarity, only one nanowire is shown. The plating step is carried out in substantially the same manner as that of Figure 2, in which a template nanowire 54 is coated with a layer 58 of the plating metal. Thereafter, the template nanowire 54 is oxidized. As a result, at least the surface of the template nanowire 54 is darkened or dulled due to the

presence of a metal oxide layer (*i.e.,* oxidized nanowire 82). The resulting composite nanowire 86 is less reflective and causes less scattering than the template nanowire 110 due to the combined effects of plating and blackening.

The oxidation of the template nanowires can be carried out by known methods in the art. Typically, the nanostructures can be oxidized in gas phase or solution phase. If necessary, oxidization can be carried out at an elevated temperature to accelerate the rate of oxidation. Methods involving gas phase oxidation include, for example, UV-ozone treatment, oxygen plasma, heating in air and heating via microwave induction. Oxidizing agents that operate in solution phase include, for example, $KMnO_4$, hydrogen peroxide, and the like.

In certain embodiments, the reduction of reflectivity and light scattering needs to be balanced against a potential decrease of the electrical conductivity of the composite nanostructures formed following the steps of plating and oxidation. Because metal oxides are typically not as conductive as pure metals, it is desirable to control the degree of oxidation by controlling the exposure time and/or strength of the oxidation agents. In particular, in the case where the plating metal is not as conductive as the first type of metal forming the template nanostructures, preserving the template nanostructures in most part (with only superficial oxidization) can improve the overall conductivity of the composite nanostructures.

In general, nanostructures described herein (including nanowires, nanotubes, or plated nanowires) can be oxidized to reduce light reflectivity and light scattering.

Additional treatments:

Additional treatments and modifications to the above processes can be performed to further reduce depolarization or to enhance certain physical features of the final conductive film.

1. Highly Aligned Nanowires

A transparent conductive film formed by highly aligned anisotropic nanostructures can lead to anisotropic properties. For example, nanowires substantially oriented along their longitudinal axes can form a conductive film with directional conductivity along the direction of the nanowire alignment. Optically, such a conductive film can function as a wire-grid polarizer. See, co-pending U.S. Patent Application No. 11/871,721, to Cambrios Technologies Corporation, the assignee of the present application.

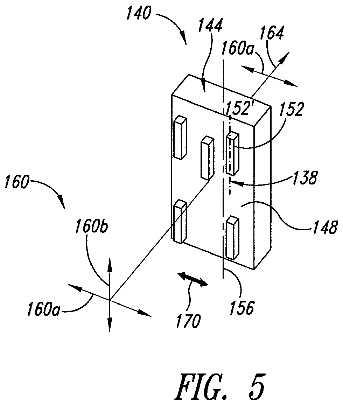

Briefly, Figure 5 illustrates schematically a conductive film 138 functioning as a wire-grid polarizer 140. As shown, the polarizer 140 comprises a substrate 144 having a surface 148. An array of nanowires 152 is arranged parallel to the surface 148. Substantially all of the nanowires 152 further orient along a principle axis 156, which is parallel to a longitudinal axis 152' of each nanowire 152. For purpose of clarity and simplicity, the nanowires are shown as unconnected. It should be understood, however, that the nanowires form contacts at their respective distal ends to create a conductive network. In addition, other anisotropic nanostructures, *e.g.,* nanotubes, can be similarly oriented to form conductive networks. As used herein, "orient" or "align" refers to the maneuver by which the respective longitudinal axes of substantially all of the anisotropic nanostructures are parallel with a pre-determined direction. "Substantially all" refers to at least 80% of the anisotropic nanostructures being oriented within 10° of the same pre-determined direction. More typically, at least 90% of the anisotropic nanostructures are oriented within 10° of the same pre-determined direction.

As shown, an incident unpolarized electromagnetic wave (*e.g.*, light) 160 is represented by two orthogonal polarization states, *i.e.,* a horizontally vibrating component 160a and a vertically vibrating component 160b. The components 160a and 160b are both perpendicular to the direction of the light propagation 164. The wave 160 enters the conductive film 138 and only the horizontally vibrating component 160a transmits through. The vertically vibrating component 160b, which is parallel to the longitudinal axis 152' of each nanowire 152, cannot move across the length of each nanowire. As a result, instead of transmitting through the conductive film 138, the vertically vibrating component 160b is absorbed or reflected by the nanowires. In other words, the polarizer 140 has a polarization direction 170, which is perpendicular to the principle axis 156, *i.e.,* the direction of the nanowire alignment.

Thus, compared to a conductive network having randomly oriented nanowires (*i.e.,* an isotropic conductive film), a highly aligned nanowire network has directional depolarization, *i.e.,* the degree of depolarization can vary depending on the relative angle between the polarization direction of the highly aligned nanowire network and that of an impinging polarized light.

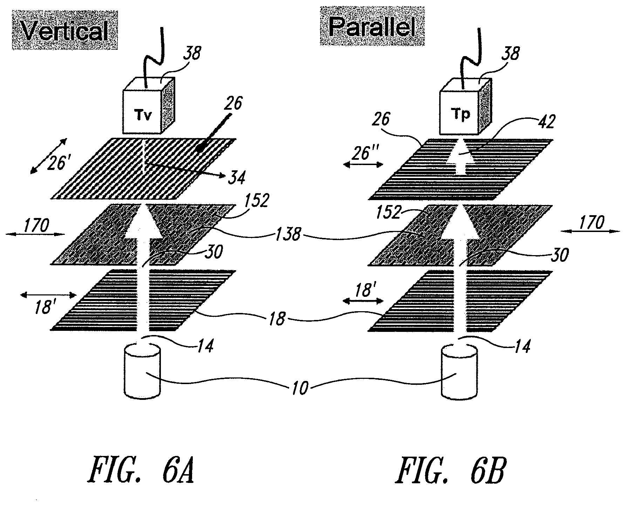

Orienting the polarization direction of a conductive film parallel to the direction of an impinging polarized light can reduce depolarization. Figures 5A and 5B schematically illustrate a system for evaluating the contrast ratio of the conductive film 138 placed between a pair of polarizers. Figure 6A shows the measurement of $T_v$ by detecting polarized light emerging from a set of polarizers having crossed transmission axes (18' and 26'). In Figure 6A, the conductive film 138 is oriented so the nanowires 152 are substantially at 90° relative to the transmission axis 18' of the first polarizer 18 and 0° relative to the transmission axis 26' of the second polarizer 26. Accordingly, the conductive film 138 has its polarization direction 170 parallel to the impinging polarized light 30, which is polarized along 18'. The degree of depolarization caused by the conductive film 138 is lower compared to an isotropic conductive film because less vertically polarized component (*i.e.,* vertical to 18' and 170) is expected to transmit through, which leads to a lowered $T_v$.

Figure 6B shows the measurement of $T_p$ by detecting polarized light emerging from a set of polarizers having parallel transmission axes (18' and 26"). In Figure 6B, the conductive film 138 is oriented so the nanowires 152 are substantially at 90° relative to the transmission axis 18' of the first polarizer 18 as well as to the transmission axis 26" of the second polarizer 26. As in Figure 6A , the conductive film 138 has its polarization direction 170 parallel to the impinging polarized light 30, which is polarized along 18'. As discussed in connection with Figure 6A, the degree of depolarization caused by the conductive film 138 is lower compared to an isotropic conductive film because less vertically polarized component (*i.e.*, vertical to 18' and 70) is expected to transmit through, which leads to a higher proportion of the polarized light 42 (*i.e.*, the polarized component along 26") and $T_p$.

Collectively, an increase in $T_p$ and a decrease in $T_v$ produce a higher contrast ratio according to Formula (1). As shown, a conductive film having highly aligned anisotropic nanostructures can be oriented in a particular direction vis-à-vis an impinging light to reduce depolarization and increase contrast ratio. Thus, in various embodiments, the methods of reducing depolarization further comprise orienting the anisotropic nanostructures having longitudinal axes such that substantially all of the anisotropic nanostructures are aligned along their respective longitudinal axes.

The alignment of the anisotropic nanostructures can be achieved by, for example, mechanically-applied or flow-induced shear force. A more detailed description can be found, for example, in co-pending U.S. Patent Application No. 11/871,721.

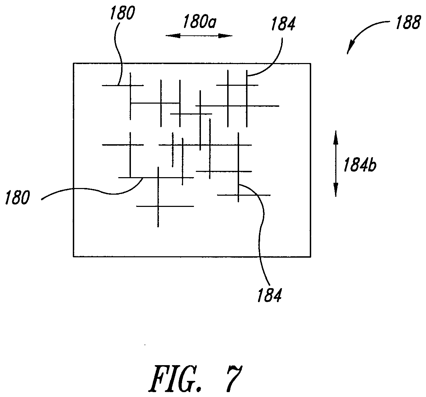

In another embodiment, shown in Figure 7, the anisotropic nanostructures (*e.g.,* nanowires) are substantially aligned in two orthogonal directions, *i.e.,* about 50% of the nanowires 180 are aligned in a first direction 180a, and the other 50% of the nanowires 184 are aligned in a right angle from the first direction 184a. This distribution of nanowires creates a highly efficient network 188, in which the connectivity of the nanowires is statistically optimized. Comparing to a network of randomly oriented nanowires, fewer nanowires are needed to produce the same level of connectivity and electrical conductivity. Fewer nanowires can significantly reduce scattering, haze, and depolarization, all of which are directly related to the number of nanostructures in the path of light. Thus, in various embodiments, the methods of reducing depolarization, as described above, further comprise orienting a first population of anisotropic nanostructures substantially along a first direction; and orienting a second population of anisotropic nanostructures substantially along a second direction, the first direction and the second direction being orthogonal to one another.

The orientation can typically take place as part of the deposition and formation of the conductive film. *See,* co-pending U.S. Patent Application No. 11/871,721. As discussed, orienting the anisotropic nanostructures in a conductive film provides further reduction of depolarization as well as reducing the reflectivity of the anisotropic nanostructures. In certain embodiments, the nanowires are deposited and oriented on a substrate prior to plating. In other embodiment, anisotropic nanostructures can be plated and etched (*e.g.*, in electro-less plating and chemical etching) prior to being deposited and oriented on a substrate.

2. Further Plating

Depending on the types of the plating metal, the conductive films prepared according to the methods described above can vary in their absorption characteristics. This can manifest in the color of the film. For example, a gold coating typically gives off a blue hue. When gold nanotubes or gold-plated blackened silver nanowires are further plated with a thin layer of nickel (e.g., 10-20 nm thick), the blue color is neutralized. The optical characteristics (absorption and transmission) of the conductive films can thus be fine-tuned by further plating of the nanostructures with a suitable metal. Moreover, the conductivity and reflectivity of the final conductive film can also be impacted by further plating.

3. Conductive Polymer Films

The nanostructure -based conductive film can be further combined with a transparent conductive polymer film. Polymer films are typically less reflective than metallic nanostructures. In addition, the conductive polymer film fills in the space between the nanostructures and improves conductivity. Finally, the polymer film (typically of neutral color) can also adjust the absorption characteristics of the composition film.

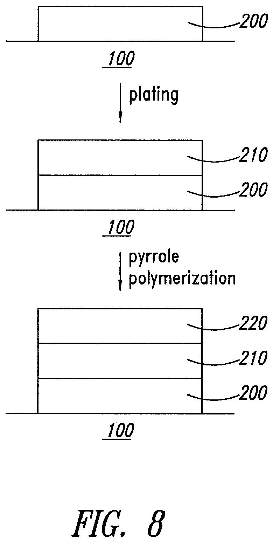

Figure 8 schematically shows the formation of a composite conductive film comprising forming a nanostructure -based conductive network 200, plating the conductive network 200 to form a coating 210, and forming a conductive polymer film 220.

The conductive polymer film is a polypyrrole film. The polypyrrole film can be produced electrochemically or chemically. Preferably, using nanostructure-based conductive network as an electrode (*i.e.,* an anode), pyrrole monomers can electrochemically polymerize and form a coating on the conductive network.

The conductive polymer film can also be formed chemically in the presence of an oxidative agent according to known methods in the art. The gold layer functions as a seed layer on which the polymerization takes place.

Other suitable conductive polymers suitable include, but are not limited to, polyparaphenylene, polythiophene, polyaniline.

4. Overcoat

An inert layer of overcoat can be deposited to stabilize and protect the nanostructure-based conductive network. The overcoat can also provide favorable optical properties, such as anti-glare and anti-reflective properties, which serve to further reduce the reflectivity of the nanostructures.

Thus, one embodiment provides a transparent conductor according to claim 1, and an overcoat over the conductive network.

Transparent conductors according to this embodiment are thermally and chemically stable. In particular, they can withstand the thermal and chemical treatments that are typical conditions for device fabrications, such as preparing color filters (*e.g.*, for a flat panel display system) that are coated with a transparent conductive film comprising metallic nanotubes (*e.g.*, gold nanotubes).

Typically, the transparent conductor is considered thermally stable when the difference in the surface resistivity of the transparent conductor before and after the heat treatment is no more than 5%. More typically, the difference is no more than 1%. The transparent conductors described herein (*e.g.*, gold nanotubes protected by an overcoat) are stable when baking at a temperature up to at least 250°C. More typically, the transparent conductor is stable at temperature up to at least 200°C, 150°C, or 100°C. The transparent conductor shows little changes in surface resistivity (less than 1%) after prolonged heat treatment (for at least about 1.5 hour, an hour, or 30 minutes) under these temperatures. For example, the transparent conductor is stable and the surface resistivity changes by less than 1% when it is baked at 200 °C for up to 1.5 hours.

The transparent conductor is also chemically stable when exposed to certain chemicals commonly used in device fabrications, such as coating a color filter. Typically, the transparent conductor is considered chemically stable when the difference in the surface resistivity of the transparent conductor before and after the chemical treatment is no more than 5%. More typically, the difference is no more than 1%.

The transparent conductor is stable when exposed a 4% solution of potassium hydroxide (KOH) for up to 5 minutes. The surface resistivity remains largely unchanged (less than 5%) after the exposure. In other embodiments, the transparent conductor is stable when exposed to a 5% solution of tetramethylammonium hydroxide (TMAH) for up to 5 minutes. The changes in the surface resistivity of the film are less than 1%.

In chemicals less caustic than the bases described above, the transparent conductor are chemically stable even after prolonged exposure. Thus, in other embodiments, the transparent conductor is stable when exposed to a 5% solution of isopropyl alcohol (IPA) for up to 30 minutes. The changes the surface resistivity of the film are less than 1 %. In yet other embodiments, the transparent conductor is stable when exposed to a 5% solution of N-methyl-2-pyrrolidone (NMP) for up to 30 minutes. The changes the surface resistivity of the film are less than 1%.

One skilled in the art will recognize that the transparent conductors described herein are also chemically stable, as defined herein, in any combinations of the above chemicals.

The overcoat can be one or more of a hard coat, an anti-reflective layer, a protective film, a barrier layer, and the like, all of which are extensively discussed in co-pending U.S. Patent Application Nos. 11/871,767 and 11/504,822.

Examples of suitable hard coats include synthetic polymers such as polyacrylics, epoxy, polyurethanes, polysilanes, silicones, poly(silico-acrylic) and so on. Suitable anti-glare materials are well known in the art, including without limitation, siloxanes, polystyrene/PMMA blend, lacquer (e.g., butyl acetate/nitrocellulose/wax/alkyd resin), polythiophenes, polypyrroles, polyurethane, nitrocellulose, and acrylates, all of which may comprise a light diffusing material such as colloidal or fumed silica. Examples of protective film include, but are not limited to: polyester, polyethylene terephthalate (PET), polybutylene terephthalate, polymethyl methacrylate (PMMA), acrylic resin, polycarbonate (PC), polystyrene, triacetate (TAC), polyvinyl alcohol, polyvinyl chloride, polyvinylidene chloride, polyethylene, ethylene-vinyl acetate copolymers, polyvinyl butyral, metal ion-crosslinked ethylene-methacrylic acid copolymers, polyurethane, cellophane, polyolefins or the like; particularly preferable are PET, PC, PMMA, or TAC.

Applications of the High Contrast Transparent Conductors

The high contrast transparent conductors prepared by any of the above-described processes can be used as functional films such as transparent electrodes, polarizers, color filters in a wide variety of devices, including all the devices that currently makes use of metal oxide films (*e.g.*, ITO). Examples of suitable devices include flat panel displays such as LCDs, plasma display panels (PDP), coatings on color filters for colored flat panel displays, touch screens, electromagnetic shield, electromagnetic interference, electrostatic discharge (ESD) films such as used in thin-film transistors , functional glasses (*e.g.,* for electrochromic windows), optoelectronic devices including EL lamps and photovoltaic cells, and the like. In addition, the transparent conductors herein can be used in flexible devices, such as flexible displays and touch screens. See, co-pending U.S. Patent Application No. 11/871,767.

EXAMPLES

EXAMPLE 1

SYNTHESIS OF SILVER NANOWIRES

Silver nanowires were synthesized by a reduction of silver nitrate dissolved in ethylene glycol in the presence of poly(vinyl pyrrolidone) (PVP). The method was described in, e.g. Y. Sun, B. Gates, B. Mayers, & Y. Xia, "Crystalline silver nanowires by soft solution processing", Nanolett, (2002), 2(2) 165-168. Uniform silver nanowires can be selectively isolated by centrifugation or other known methods.

Alternatively, uniform silver nanowires can be synthesized directly by the addition of a suitable ionic additive (*e.g.*, tetrabutylammonium chloride) to the above reaction mixture. The silver nanowires thus produced can be used directly without a separate step of size-selection. This synthesis is described in more detail in U.S. Provisional Application No. 60/815,627, in the name of Cambrios Technologies Corporation, the assignee of the present application, which application is incorporated herein in it entirety.

In the following examples, silver nanowires of 30nm to 80nm in width and about $8\mu m$-$25\mu m$ in length were used. Typically, better optical properties (higher transmission and lower haze) can be achieved with higher aspect ratio wires (*i.e.* longer and thinner).

EXAMPLE 2

PREPARATION OF NANOWIRE-BASED CONDUCTIVE FILMS

The nanowires can be formulated into an ink composition prior to deposition and optional orientation on a substrate.

A typical ink composition comprises, by weight, from 0.0025% to 0.1% surfactant (*e.g.*, a preferred range is from 0.0025% to 0.05% for Zonyl® FSO-100), from 0.02% to 4% viscosity modifier (*e.g.*, a preferred range is 0.02% to 0.5% for hydroxypropylmethylcellulose or HPMC), from 94.5% to 99.0% solvent and from 0.05% to 1.4% metal nanowires. Representative examples of suitable surfactants include Zonyl® FSN, Zonyl® FSO, Zonyl® FSH, Triton (x100, x114, x45), Dynol (604, 607), n-Dodecyl b-D-maltoside and Novek. Examples of suitable viscosity modifiers include hydroxypropyl methyl cellulose (HPMC), methyl cellulose, xanthan gum, polyvinyl alcohol, carboxy methyl cellulose, hydroxy ethyl cellulose. Examples of suitable solvents include water and isopropanol.

The ink composition can be prepared based on a desired concentration of the nanowires, which is an index of the loading density of the final conductive film formed on the substrate.

The substrate can be any material onto which nanowires are deposited. The substrate can be rigid or flexible. Preferably, the substrate is also optically clear, *i.e.,* light transmission of the material is at least 80% in the visible region (400nm - 700nm).

Examples of rigid substrates include glass, polycarbonates, acrylics, and the like. In particular, specialty glass such as alkali-free glass (*e.g.*, borosilicate), low alkali glass, and zero-expansion glass-ceramic can be used. The specialty glass is particularly suited for thin panel display systems, including Liquid Crystal Display (LCD).

Examples of flexible substrates include, but are not limited to: polyesters (*e.g.,* polyethylene terephthalate (PET), polyester naphthalate, and polycarbonate), polyolefins (*e.g.*, linear, branched, and cyclic polyolefins), polyvinyls (*e.g.,* polyvinyl chloride, polyvinylidene chloride, polyvinyl acetals, polystyrene, polyacrylates, and the like), cellulose ester bases (*e.g.*, cellulose triacetate, cellulose acetate), polysulphones such as polyethersulphone, polyimides, silicones and other conventional polymeric films.

The ink composition can be deposited on the substrate according to, for example, the methods described in co-pending U.S. Patent Application No. 11/504,822.

As a specific example, an aqueous dispersion of silver nanowires, *i.e.,* an ink composition was first prepared. The silver nanowires were about 35nm to 45nm in width and around $10\mu m$ in length. The ink composition comprises, by weight, 0.2% silver nanowires, 0.4% HPMC, and 0.025% Triton x100. The ink was then spin-coated on glass at a speed of 500rpm for 60s, followed by post-baking at 50C for 90s and 180c for 90s. The coated film had a resistivity of about 20 ohms/sq, with a transmission of 96% (using glass as a reference) and a haze of 3.3%. As understood by one skilled in the art, other deposition techniques can be employed, *e.g.*, sedimentation flow metered by a narrow channel, die flow, flow on an incline, slit coating and the like. It is further understood that the viscosity and shear behavior of the fluid as well as the interactions between the nanowires may affect the distribution and interconnectivity of the nanowires deposited.

EXAMPLE 3

EVALUATION OF OPTICAL AND ELECTRICAL PROPERTIES OF TRANSPARENT CONDUCTORS

The transparent conductors prepared according to the methods described herein were evaluated to establish their optical and electrical properties.

The light transmission data were obtained according to the methodology in ASTM D1003. Haze was measured using a BYK Gardner Haze-gard Plus. Unless specified otherwise, the light transmission and haze are measured in the presence of a glass substrate. The surface resistivity was measured using a Fluke 175 True RMS Multimeter or contactless resistance meter, Delcom model 717B conductance monitor.

The interconnectivity of the nanowires and an areal coverage of the substrate can also be observed under an optical or scanning electron microscope.

EXAMPLE 4

EVALUATION OF CONTRAST RATIO

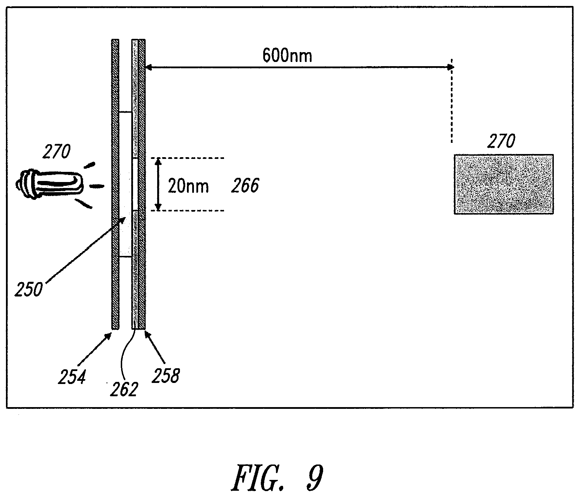

Figure 9 illustrates a system for evaluating the contrast ratio of a transparent conductor. As shown, the transparent conductor sample 250 is placed between a stationary polarizer 254 and a rotating polarizer 258. A mask 262 having an aperture (about 20nm) 266 is placed between the transparent conductor sample 250 and the rotating polarizer 258. A light source 270 provides unpolarized incident light. A detector 274 is positioned about 600mm away from rotating polarizer and detects $T_p$ and $T_v$ emerging from the aperture 266.

For measuring $T_p$, the rotating polarizer 258 is initially positioned such that its transmission axis is in parallel alignment with the transmission axis of the stationary polarizer 254 (*see, also,* Figure 1B). A number of measurements of the transmission can be taken by varying the rotating polarizers 258 in small-degree intervals from the initial position to ensure that the highest $T_p$ is obtained.

For measuring $T_v$, the rotating polarizer 258 is initially positioned such that its transmission axis is in vertical or perpendicular relative to the transmission axis of the stationary polarizer 254 (*see, also,* Figure 1A). A number of measurements of the transmission can be taken by varying the rotating polarizers 258 in small-degree intervals from the initial position to ensure that the lowest $T_p$ is obtained.

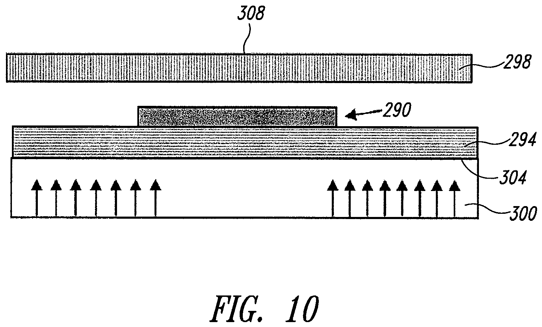

Figure 10 illustrates direct visualization to qualitatively evaluate the contrast ratio of a transparent conductor sample. As shown, the transparent conductor sample 290 is positioned between a first polarizer 294 and a second polarizer 298. The relative positions of the transmission axes of the two polarizers are adjustable by rotating one or both polarizers. A light source 300 directs unpolarized light from a bottom surface 204 of the first polarizer 294. The emerging light from a top surface 308 of the second polarizer 298 can be directly inspected. Samples with higher contrast ratio appeared darker.

EXAMPLE 5

GOLD PLATING AND OXIDATION

Three samples of conductive films were prepared according to the method described in Example 2. Samples #1-3 were formed of silver nanowires in decreasing levels of surface density. Each sample included a set of identically prepared glass slides coated with conductive films of the same density and formed of the silver nanowires. The silver nanowires on each slide were electrochemically plated with a layer of gold for a specific period of time, followed by oxidation of the underlying silver nanowires.

The optical and electrical properties of the samples, including transmission (T%), haze (H%) and resistivity (Ω) were measured according to the methods described in Example 3. The contrast ratio was evaluated according to the method described in Example 4 and calculated according to Formula (1).

Gold Plating:

A Princeton Applied Research (Princeton, NJ) 263 potentiostat/galvanostat was used in all electrochemical experiments. A copper foil 1 in x1 in was used as the counter electrode. A glass slide coated with silver nanowires was the working electrode. Both electrodes were immersed in a gold plating solution: Technic 40 GOLD STRIKE RTU®. A current (1 mA/in$^2$) was applied to the electrodes and the plating took place for 2 seconds to 120 seconds. The deposited films were then thoroughly rinsed with deionized water and dried in the air.

For each sample, transmission (T%), haze (H%) and resistivity (Ω) were measured as a function of the plating time. Where the plating time was indicated as zero, bare nanowire films were measured. These data were shown in Tables 1-3, which correspond to Samples 1-3, respectively.

As shown in Tables 1-3, plating time, which determined the thickness of the gold coating, mildly affected the light transmission of the gold-plated conductive films. A slight decrease in transmission (about 20% at the most) was observed in all the samples as the plating progressed. The samples also showed increased haze and reduced resistivity as the plating progressed.

Oxidation:

A Princeton Applied Research (Princeton, NJ) 263 potentiostat/galvanostat was used in all electrochemical experiments. A platinum foil 1in x1in was used as counter electrode. The working electrode was gold-silver nanowires coated glass slide. The electrolyte was 0.1 M sodium sulfate. Silver oxidation was performed by sweeping the potential from 0 to 0.8 V versus SCE (saturated calomel electrode), and the scan rate was 20 mV/s. The oxidized films were then thoroughly rinsed with deionized water and dried in the air.

It was observed the light transmission was substantially unchanged in the oxidized films as compared to the gold-plated films. However, the oxidation significantly reduced the haze values and increased contrast ratio in most of the films. The most dramatic increase in contrast ratio was observed in Sample 1 (in the film that was subjected to 10 seconds of gold plating), in which the contrast ratio (CR = 7794) increased by nearly 80 fold as compared to the bare silver nanowire sample (CR = ~100) and 60 fold as compared to the oxidized nanowire sample with no plating (CR = 130).

Furthermore, the resistivity was observed to be related to the thickness of the gold coating and the wire density of the initial film formed of the nanowires. The oxidation step caused a decrease in conductivity (*i.e.,* increase in resistivity) in nearly all but the films with the thickest gold plating. The results were consistent with the fact that silver oxide is less conductive than silver. Because the underlying silver nanowires were insulated from oxidation in films having the thickest gold plating; the conductivities in those films were substantially unchanged.

As shown, conductive films could achieve high contrast ratio following plating and oxidation. In certain circumstances, the increase in contrast ratio may have to be accomplished at the expense of slight loss of conductivity. However, a balance between conductivity and contrast ratio could be struck such that an optimal set of parameters is reached.

TABLE 1

| SAMPLE 1: AG111-5 (WIRE SURFACE DENSITY: 5%) | | | | | | |
|---|---|---|---|---|---|---|
| Plating time (s) | Gold Plating | | | After Oxidation | | |
| | H (%) | T (%) | R ($\Omega/\square$) | H (%) | T (%) | R ($\Omega/\square$) | CR |
| 0 | 3.07 | 88.2 | 21.72 | 1.67 | 89.1 | 57 | 130 |
| 2s | 3.27 | 87.6 | 21.03 | 0.86 | 89.5 | 1613 | 503 |
| 5s | 2.97 | 87.6 | 17.30 | 0.2 | 90.2 | 967 | 5619 |
| 10s | 3.19 | 87.2 | 16.30 | 0.19 | 89.2 | 372 | 7794 |
| 20s | 3.63 | 86.4 | 21.24 | 0.45 | 86.9 | 188 | 3248 |
| 30s | 4.12 | 84.9 | 21.84 | 1.25 | 85.5 | 83 | 515 |
| 60s | 5.72 | 81.9 | 13.41 | 5.4 | 82.3 | 12.3 | 56 |
| 120s | 8.8 | 76.8 | 9.24 | 8.74 | 77.8 | 8.17 | 34 |

TABLE 2

| SAMPLE 2: AG111-3 (WIRE SURFACE DENSITY: 8%) | | | | | | |
|---|---|---|---|---|---|---|
| Plating time (s) | Gold Plating | | | After Oxidation | | |
| | H (%) | T (%) | R ($\Omega/\square$) | H (%) | T (%) | R ($\Omega/\square$) | CR |
| 0 | 4.98 | 85.8 | 11.34 | 2.47 | 87.1 | 45 | 120 |
| 2s | 5.5 | 83.4 | 12.86 | 0.31 | 89.3 | 2464 | 1846 |
| 5s | 5.38 | 83.4 | 11.42 | 0.24 | 89.7 | 4923 | 2727 |

(continued)

| SAMPLE 2: AG111-3 (WIRE SURFACE DENSITY: 8%) | | | | | | | |
|---|---|---|---|---|---|---|---|
| Plating time (s) | Gold Plating | | | After Oxidation | | | |
| 10s | 6.2 | 81.4 | 15.69 | 0.53 | 86.9 | 1239 | 1208 |
| 20s | 6.39 | 80.9 | 11.70 | 0.41 | 85.6 | 306 | 1760 |
| 30s | 5.89 | 81.6 | 9.763 | 0.43 | 84.2 | 133 | 2453 |
| 60s | 7.34 | 78.1 | 7.234 | 1.15 | 76.4 | 45 | 336 |
| 120s | 9.4 | 75.2 | 5.191 | 9.06 | 74.8 | 5.78 | 34 |

TABLE 3

| SAMPLE 3: AG119-1 (WIRE SURFACE DENSITY: 10%) | | | | | | | |
|---|---|---|---|---|---|---|---|
| Plating time (s) | Gold Plating | | | After Oxidation | | | |
| | H (%) | T (%) | R ($\Omega/\square$) | H (%) | T (%) | R ($\Omega/\square$) | CR |
| 0 | 7.7 | 83.1 | 8.153 | | | | 37 |
| 20s | 8.22 | 78.6 | 6.10 | 0.46 | 84.3 | 167.6 | 4169 |
| 30s | 8.72 | 77.7 | 6.78 | 0.84 | 81.4 | 70.62 | 2181 |
| 40s | 9.91 | 74.7 | 5.45 | 1.53 | 76.4 | 35.21 | 1192 |
| 60s | 10.2 | 74.1 | 4.86 | 3.06 | 71.2 | 19.17 | 192 |
| 90s | 12.9 | 68.9 | 4.79 | 5.02 | 64.6 | 17.3 | 85 |

EXAMPLE 6

GOLD NANOTUBES -- ELECTRO-LESS PLATING AND CHEMICAL ETCHING

Silver nanowires were prepared and formed into thin films on glass slides according to methods described herein. The silver nanowires of the thin films were further plated with a thin layer of gold by electro-less plating or solution phase plating, followed by chemical etching (*see, also* Figure 3A)

Stapleton gold plating systems were used to conduct the eletro-less plating. Microgold® 291 (Stapleton Technologies Corp.) could be adjusted to plate gold on a suitable substrate at 3-10 microinches/minute (76nm-254nm/minute). The plating time was 2 minutes for each plating system, represented by different concentrations of the plating solution. For a given plating time (*e.g.*, 2 minutes), the more diluted the plating solution was, the thinner the gold coating was plated.

It was observed that the films formed by gold plated silver nanowires (*i.e.*, "gold-plated films") were less conductive than the bare silver nanowire films. Optically, the haze and transmission values in gold-plated films were substantially unchanged compared to the bare silver nanowire films (*see*, Table 4).

The gold-plated films were subsequently etched in solution phase for 2 minutes in the presence of 10 ppm $KMnO_4$, 1% $NaNO_3$, and 1% $HNO_3$ to produce final films composed of gold nanotubes.

Although the light transmission was largely unaffected by the etching, the haze values were significantly reduced in the final films following etching which removes the template silver nanowires. The reduced haze value is an indicator of diminished reflectivity and light scattering, which events also lead to increased contrast ratios.

In addition, Table 4 shows a correlation between the thickness of the gold coating (*i.e.,* the thickness of the wall of the gold nanotubes) and the contrast ratio. There is a clear trend that as the gold coating gets thinner (plated by more diluted plating solutions), films of higher contrast ratios were obtained.

The final films exhibited lowered conductivity, which appeared to be a cost for increasing the contrast ratio. The results were also consistent with the fact that gold is generally less conductive than silver.

TABLE 4

| Microgold® 291 | Gold Plating (2 minutes) | | | Etching (2 minutes) | | | |
|---|---|---|---|---|---|---|---|
| | H (%) | T (%) | R ($\Omega/\square$) | H (%) | T (%) | R ($\Omega/\square$) | CR |
| 0 (Bare wires) | 4.34 | 86.3 | 14.28 | | | | |
| 4% | 3.46 | 76.6 | 89.86 | 2.23 | 77.8 | 151 | 183 |
| 2% | 3.51 | 76.3 | 78.83 | 1.13 | 79.4 | 260 | 666 |
| 1% | 3.56 | 77.1 | 71.76 | 0.72 | 81.9 | 259 | 1407 |
| 0.5% | 3.08 | 80.0 | 47.61 | 0.84 | 81.6 | 257 | 1016 |
| 0.25% | 4.26 | 74.8 | 40.56 | 0.38 | 86.2 | 775 | 4340 |
| 0.12% | 3.53 | 82.9 | 63.97 | 0.24 | 88.2 | 1459 | 5390 |

EXAMPLE 7

ETCHING VS. OXIDATION

Two silver nanowires films were prepared according to Example 2. The films were electroplated for 20 seconds according to the method described in Example 5 to achieve the same gold coating. One film was subjected to electro-etching to remove the template silver nanowires, while the other was oxidized to blacken the template silver nanowires.

During the electro-etching, a Princeton Applied Research (Princeton, NJ) 263 potentiostat/galvanostat was used. A platinum foil 1in x1in was used as the counter electrode. A glass slide coated with gold-silver nanowires was used as the working electrode. The electrolyte was 5%NaNO$_3$ with 5% HNO$_3$. Silver etching was performed by sweeping the potential from 0 to 0.8 V versus SCE (saturated calomel electrode) at a scan rate of 20 mV/s. The etched films were then thoroughly rinsed with deionized water and dried in the air.

The oxidation was carried out in the method described in Example 5.

The results were shown in Table 5. Electro-etching and oxidation had substantially the same impact on the electrical and optical properties in the final films. Both increase the contrast ratio by more than 20 fold compared to bare silver nanowire films (CR = ~100).

TABLE 5

| | Gold Plating (20 seconds) | | | Post-plating Treatment | | | |
|---|---|---|---|---|---|---|---|
| | H (%) | T (%) | R ($\Omega/\square$) | H (%) | T (%) | R ($\Omega/\square$) | CR |
| Bare wires (Ag) | 5.9 | 83.9 | 15.42 | | | | |
| Gold-plated followed by electro-etching | 6.26 | 81.3 | 10.25 | 0.41 | 85.5 | 169 | 2185 |
| Gold-plated followed by oxidation | 6.04 | 81.7 | 9.68 | 0.41 | 85.9 | 118 | 2750 |

EXAMPLE 8

ELECTRO-ETCHING AND CHEMICAL ETCHING

Two silver nanowires films were prepared according to Example 2. The films were electroplated for 20 seconds according to the method described in Example 5 to achieve the same gold coating. One film was subjected to electro-etching to remove the template silver nanowires, while the other was subjected to chemical etching.

The electro-etching was carried out according to the method described in Example 7.

In the chemical etching, the film was exposed to the etchant for different durations of time, while the transmission, haze, resistivity and contrast ratio were evaluated as a function of the etching time.

As shown in Table 6, both electro-etching and chemical etching were capable of significantly improving the contrast ratio by removing the reflective silver nanowires. Chemical etching for 2 minutes increased the contrast ratio by more than 40 fold compared to that of a bared silver nanowire film (CR = ~100). Electro-etching also increased the contrast ratio, but to a lesser degree.

TABLE 6

| | Gold Plating (20 seconds) | | | Etching | | | | |
|---|---|---|---|---|---|---|---|---|
| | H (%) | T (%) | R (Ω/□) | Time (s) | H (%) | T (%) | R (Ω/□) | CR |
| Bare wires (Ag) | 5.9 | 83.9 | 15.42 | | | | | |
| Gold-plated followed by electro-etching | 6.26 | 81.3 | 10.25 | 40 | 0.41 | 85.5 | 169 | 2185 |
| Gold-plated followed by chemical etching (seconds) | 5.71 | 82.2 | 10.17 | 30 | 4.29 | 82.7 | 18 | 66 |
| | 5.52 | 82.3 | 9.97 | 60 | 3.41 | 83 | 21 | 93 |
| | 6.10 | 81.1 | 10.55 | 90 | 2.58 | 82.8 | 37 | 133 |
| | 5.90 | 82.1 | 10.44 | 110 | 0.64 | 84.8 | 116 | 866 |
| | 6.09 | 81.3 | 11.94 | 120 | 0.23 | 85.8 | 276 | 4150 |

EXAMPLE 9

ADDITIONAL TREATMENT - OVERCOAT

Optically clear overcoats were deposited on conductive films formed of gold nanotubes, which were prepared through gold-plating and etching of silver nanowires. The additional overcoat functions as a protection layer and also increases the adhesion between metal wires and the underneath substrate. One overcoat material was Optically Clear UV-curable Hard Coat, *i.e.*, AC HC-5619 (by Addison Clear Wave). Table 7 showed optical and electrical properties of a gold tube sample with hard coat AC HC-5619. It is observed that the overcoat did not affect the coated film.

TABLE 7

| Overcoat | H (%) | T (%) | R (Ω/□) | CR |
|---|---|---|---|---|
| None | 0.15 | 88.4 | 327.8 | 7918 |
| AC | 0.19 | 88.7 | 315.4 | 6184 |

EXAMPLE 10

FILM FORMATION BASED ON GOLD-COATED SILVER NANOWIRES FOLLOWED BY ETCHING

Gold-coated silver nanowires were prepared in solution phase according to an electroless plating process. The gold-coated silver nanowires were formulated into an ink composition and deposited on glass to form a conductive film. The conductive film was further etched to convert the gold-plated silver nanowires to gold nanotubes (*see, also* Figure 3B)

Electroless Plating:

Silver nanowires (100ppm) in a solution containing 50ppm gold plating solution (Microgold® 291) 1000ppm poly(vinylpyrrolidone) (PVP) and 3000pppm $NH_4OH$ was coated with gold. The thickness of the gold coating can be controlled by adjusting the concentration of the plating solution and the plating time (*see, also,* Example 6).

Film Formation:

The gold-coated silver nanowires were allowed to settle overnight and the supernatant liquid was removed. The resulting sediment was re-solvated with 1000ppm PVP and 300ppm $NH_3$ in water. Following this solvent exchange, the dispersion was filtered through a filter (*e.g.*, 0.8µm sieves). The gold-coated silver nanowire residues remaining in the filter was re-solvated with deionized water. This process can be repeated several times.
An ink composition was formulated by dispersing 0.12% gold-coated silver nanowires, 0.4% HPMC, and 0.025% Triton x100 in deionized water. The ink composition was spin-coated on Eagle 2000 glass (150 x 150 mm) at 500 rpm for 30s to form a film. The concentration of the gold-coated silver nanowires can be adjusted to control the resistivity of the film.

The films were baked at 50 °C for 90 seconds then at 180 °C for 90 seconds.

Electroless Etching:

Silver etching was carried out in 1% $(NH_4)_2S_2O_8$ and 0.3% $NH_4OH$ for 1 minute to convert the gold-coated silver nanowires to gold nanotubes. The final, etched films were thoroughly rinsed with deionized water and dried in the air, followed by baking at 180 °C for 90 seconds. Optionally, an overcoat can be further coated and cured on the final films (*see*, *also* Example 9).

The final films (composed of gold nanotubes) had, on average, 0.15% haze, 89.8% transmission, 1086 Ω/□ in resistivity and 5542 in contrast ratio.

EXAMPLE 11

NANOTUBE FORMATION FOLLOWED BY FILM FORMATION

Gold nanotubes were prepared in a solution phase by first coating gold on silver nanowires according to an electroless plating process followed by etching the silver nanowires. The resulting gold nanotubes were formulated into an ink composition, which was cast into conductive films (*see, also* Figure 3C).

Electroless Plating:

Silver nanowires (100ppm) in a solution containing 50ppm gold plating solution (Microgold® 291) 1000ppm poly(vinylpyrrolidone) (PVP) and 3000pppm $NH_4OH$ was coated with gold. The thickness of the gold coating can be controlled by adjusting the concentration of the plating solution and the plating time (*see, also,* Example 6).

Electroless Etching:

The gold-coated silver nanowires were allowed to settle overnight and the supernatant liquid was removed. The resulting sediment was re-solvated with 1000ppm PVP and 300ppm $NH_3$ in water. Following this solvent exchange, the dispersion was filtered through a filter (*e.g.*, $0.8\mu m$ sieves). The gold-coated silver nanowire residues remaining in the filter was re-solvated into an etchant containing 1% $(NH_4)_2S_2O_8$. Gold nanotubes were formed in the solution phase. The etchant solvent was exchanged with deionized water through several cycles of filtration and re-solvation.

Film Formation:

An ink composition was formulated by dispersing 0.2% gold nanotubes, 0.4% HPMC, and 0.025% Triton x100 in deionized water. The ink composition was spin-coated on Eagle 2000 glass (150 x 150 mm) at 500 rpm for 30s to form a film. The concentration of the gold-coated silver nanowires can be adjusted to control the resistivity of the film.

The films were air dried then baked at 180 °C for 90 seconds. Optionally, the films can be further coated with an overcoat (*see, also* Example 9).

The final films (composed of gold nanotubes) had, on average, 0.31% haze, 89.1% transmission, 699 Ω/□ in resistivity and 5005 in contrast ratio.

EXAMPLE 12

CHEMICAL AND THERMAL STABILITY OF GOLD NANOTUBE FILMS

Conductive films composed of gold nanotubes as prepared herein exhibited thermal and chemical stability. The optical and electrical properties of the conductive films were unaffected when subjected to thermal and chemical treatments. In this example, the thermal and chemical treatments are typical conditions for preparing color filters (*e.g.*, for a flat panel display system) that are coated with a transparent conductive film comprising metallic nanotubes (*e.g.*, gold nanotubes).

Table 8 shows that a transparent conductive film (with ACW overcoat) was stable after prolonged baking at 230 °C. The transparent conductive film was formed by a network of gold nanotubes according to Example 10. The dimensions of the average gold nanotubes are as following: about 10 $\mu m$ in length, an outside diameter of about 60 nm, an interior diameter of about 40 nm, with a wall thickness of about 10nm. As shown, the percentage change in resistivity was less than 1%. The optical properties also remained unchanged compared to untreated films.

TABLE 8

| Thermal Treatment | H (%) | T (%) | R ($\Omega/\square$) | %$\Delta$R |
|---|---|---|---|---|
| No treatment | 0.32 | 90.0 | 1075 | --- |
| Baking at 230 °C (1 hour) | 0.35 | 90.2 | 1063 | <1 % |
| Baking at 230 °C (additional 0.5 hour) | 0.37 | 90.2 | 1000 | <1 % |

It was further observed that the temperature stability of gold nanotubes depends on the thickness of their walls. Thicker walls typically afford better temperature stability. However, thicker walls can also lead to a lowered contrast ratio. As shown, the wall thickness of the nanotubes can be controlled (*e.g.*, by adjusting the plating time) to arrive at an optimized set of parameters including stability and contrast ratio.

Table 9 shows that a transparent conductive film formed of gold nanotubes (with ACW overcoat) was stable after being submerged in a number of chemicals including potassium hydroxide (KOH), tetramethylammonium hydroxide (TMAH), isopropyl alcohol (IPA) and N-methyl-2-pyrrolidone (NMP). The transparent conductive film was formed by a network of gold nanotubes according to Example 2 and 6. The dimensions of the average gold nanotubes are as following: about 10 $\mu$m in length, an outside diameter of about 60 nm, an interior diameter of about 40 nm, with a wall thickness of about 10nm. As shown, the resistivities of the films were largely unchanged after exposure to the chemicals.

TABLE 9

| Chemical Treatment | H (%) | T (%) | R ($\Omega/\square$) | CR | %$\Delta$R |
|---|---|---|---|---|---|
| No treatment | 0.24 | 89.3 | 700 | 4000 | -- |
| 4% KOH (5 minutes) | 0.22 | 89.4 | 724 | -- | 5% |
| 5% TMAH (5 minutes) | -- | -- | -- | -- | <1 % |
| IPA (30 minutes) | 0.39 | 88.9 | 675 | -- | <1 % |
| NMP (30 minutes) | -- | -- | -- | -- | <1 % |

EXAMPLE 13

PALLADIUM NANOTUBES

Palladium nanotubes were formed by first plating palladium on a silver nanowire conductive network, followed by etching the underlying silver nanowires.

Plating:

Princeton Applied Research (Princeton, NJ) 263 potentiostat/galvanostat was used for palladium (Pd) plating experiments. A platinum mesh 1in x1in was used as the counter electrode. A glass slide coated with silver nanowires was the working electrode. Both electrodes were immersed in a palladium plating solution: Technic PALLASPEED VHS RTU®. A current (2 mA/in$^2$) was applied to the electrodes and the plating took place for 10s and 20s. The deposited films were then thoroughly rinsed with deionized water and dried in the air.

Chemical Etching:

An etchant mixture comprising: 10 ppm $KMnO_4$, 1% $NaNO_3$, and 1% $HNO_3$ was used and the etching was carried out for 1 min. Following etching, the final films, which comprise palladium nanotubes, were thoroughly rinsed with deionized water and dried in the air.

Results:

The optical and electrical properties of the samples, including transmission (T%), haze (H%) and resistivity ($\Omega$) were measured following plating as well as following etching. The contrast ratios of the final films were evaluated according to the method described in Example 4 and calculated according to Formula (1). The results are shown in Table 10.

TABLE 10

| Plating Time (s) | Palladium Plating | | | After Etching | | | |
|---|---|---|---|---|---|---|---|
| | H (%) | T (%) | R (Ω/□) | H (%) | T (%) | R (Ω/□) | CR |
| 0 | 4.01 | 81.8 | 15.19 | | | | |
| 10 | 0.87 | 82.4 | 980.3 | 0.32 | 85.9 | ~2000 | ~4000 |
| 20 | 1.55 | 78.7 | 375.9 | 0.65 | 81.5 | ~4000 | ~1000 |

As shown, because palladium is generally less conductive than silver, the films formed of palladium nanotubes show higher resistivities than films formed of the bare silver nanowires, which typically have a contrast ratio of about 100.

Like gold nanotubes, palladium nanotubes can form conductive films with contrast ratio as high as 4000 when plating was carried out for 10 seconds. At longer plating time (*e.g.*, 20 seconds), more palladium was plated to form a thicker film. As a result of the film thickness, the contrast ratio was reduced. Accordingly, by adjusting the plating time, one can adjust the thickness to optimize the contrast ratio of the final film.

EXAMPLE 14

SILVER NANOWIRE/POLYPYRROLE FILMS

Pyrrole monomers were plated chemically (electro-less) in the presence of silver nitrate, which served as an oxidant.

As shown in Table 11, in the absence of a gold coating, the polypyrrole film alone did not significantly improve the contrast ratio of the composite film as compared to that of the bare silver nanowire films.

TABLE 11

| Samples | AgNO$_3$ | H (%) | T (%) | R (Ω/□) | CR |
|---|---|---|---|---|---|
| Bare Ag Film | | 2.82 | 88.8 | 42 | 92 |
| Ag/polypyrrole | 0.5% | 3.14 | 83.2 | 55 | 182 |
| | 1% | 2.88 | 84.9 | 125 | 224 |
| | 2% | 4.06 | 77.6 | 50 | 123 |
| | 4% | 3.94 | 82.8 | 112 | 194 |
| | 8% | 6.82 | 71.8 | 56 | 93 |

The invention is not limited except as by the appended claims.

**Claims**

1. A transparent conductor (22) forming a transparent electrode in a display or a touchscreen, including: a substrate (62); and a conductive network (78) on the substrate, the conductive network (78) comprising a plurality of metal nanotubes (66) or composite nanowires (86), wherein each composite nanowire (86) comprises a template nanostructure (54) made of a first type of metal that is plated with a second type of metal (58) and in which the template nanostructure of the first type of metal is oxidized at least at its surface, wherein the transparent conductor has a contrast ratio of greater than 1000.

2. The transparent conductor (22) of claim 1 wherein said display or touchscreen is flexible.

3. The transparent conductor (22) of claim 1 wherein the contrast ratio is greater than 3000, preferably greater than 5000.

**4.** The transparent conductor (22) of claim 1 having a light transmission of greater than 85%, preferably greater than 90%, and most preferably greater than 95%.

**5.** The transparent conductor (22) of claim 1 having a surface resistivity of less than 1000 $\Omega$/sq, preferably of less than 500 $\Omega$/sq, and most preferably of less than 100 $\Omega$/sq.

**6.** The transparent conductor (22) of claim 1 wherein the transparent conductor has a haze of less than 5%, preferably of less than 1%.

**7.** The transparent conductor (22) of claim 1 wherein the metal nanotubes are gold nanotubes.

**8.** The transparent conductor (22) of claim 1 wherein the metal nanotubes are alloy or bimetallic nanotubes, in particular gold/silver alloy or bimetallic nanotubes.

**9.** The transparent conductor (22) of claim 1 further comprising an overcoat over the conductive network.

**10.** A process of forming a transparent electrode of a display or a touch screen, comprising: forming template nanostructures (54) of a first type of metallic material; plating each of the template nanostructure with a plating metal (58) of a second type of metallic material to form plated template nanostructures (66); etching the template nanostructures to form hollow nanostructures (66) of the plating metal; and depositing the hollow nanostructures on a substrate to form a conductive network (78), wherein the conductive network has a contrast ratio of higher than 1000.

**11.** The process of claim 10 further comprising, after depositing, aligning substantially all of the hollow nanostructures along their respective longitudinal axes,
wherein the depositing preferably comprises depositing and orienting a first population of the hollow nanostructures along a first direction, and depositing and orienting a second population of the hollow nanostructures along a second direction, the first direction and the second direction being orthogonal to one another.

**12.** The process of claim 10 wherein the plating is carried out by electroplating, electro-less plating or metal-metal displacement, or
wherein the etching is carried out electrochemically or chemically, or
wherein the plating is carried out by electro-less plating and the etching is carried out chemically in a solution phase.

**13.** The process of claim 10, wherein said display or touchscreen is flexible.

**14.** The process of claim 10 wherein the template nanostructures are anisotropic nanostructures,
wherein the hollow nanostructure preferably has a wall thickness that is less than a diameter of the template nanostructure.

**15.** The process of claim 14 wherein the template nanostructures are metallic nanowires, in particular silver nanowires, preferably
silver nanowires being about 30-80nm in diameters, and
the plating metal is gold, palladium, nickel, or platinum, wherein the nanotubes are preferably 10-20nm thick.

**Patentansprüche**

**1.** Transparenter Leiter (22), der eine transparente Elektrode in einer Anzeige oder einem Touchscreen bildet, umfassend: ein Substrat (62) und ein leitfähiges Netzwerk (78) auf dem Substrat, wobei das leitfähige Netzwerk (78) eine Mehrzahl von Metallnanoröhren (66) oder Komposit-Nanodrähte (86) umfasst, wobei ein jeder Komposit-Nanodraht (86) eine Schablonen-Nanostruktur (54) umfasst, die aus einem Metall eines ersten Typs hergestellt ist, welches mit einem Metall (58) einen zweiten Typs beschichtet ist, und bei dem die Schablonen-Nanostruktur aus dem Metall ersten Typs zumindest an seiner Oberfläche oxidiert ist,
wobei der transparente Leiter ein Kontrastverhältnis von mehr als 1000 hat.

**2.** Transparenter Leiter (22) nach Anspruch 1, wobei die Anzeige oder das Touchscreen flexibel ist.

3. Transparenter Leiter (22) nach Anspruch 1, wobei das Kontrastverhältnis größer als 3000 ist, vorzugsweise größer als 5000.

4. Transparenter Leiter (22) nach Anspruch 1, mit einer Lichttransmission, die höher als 85%, vorzugsweise höher als 90% und am meisten bevorzugt höher als 95% ist.

5. Transparenter Leiter (22) nach Anspruch 1, mit einer Oberflächenleitfähigkeit von weniger als 1000 Ω/sq, vorzugsweise von weniger als 500 Ω/sq, und am meisten bevorzugt von weniger als 100 Ω/sq.

6. Transparenter Leiter (22) nach Anspruch 1, wobei der transparente Leiter eine Trübheit (Haze) von weniger als 5% hat, vorzugsweise von weniger als 1% hat.

7. Transparenter Leiter (22) nach Anspruch 1, wobei die Metall-Nanoröhren Gold-Nanoröhren sind.

8. Transparenter Leiter (22) nach Anspruch 1, wobei die Metall-Nanoröhren Legierungs- oder Bimetall-Nanoröhren sind, insbesondere Legierungs- oder Bimetall-Nanoröhren aus Gold/Silber.

9. Transparenter Leiter (22) nach Anspruch 1, der ferner eine Beschichtung über dem leitfähigen Netzwerk hat.

10. Verfahren zum Ausbilden einer transparenten Elektrode einer Anzeige oder eines Touchscreens, das Folgendes umfasst: Ausbilden von Schablonen-Nanostrukturen (54) aus einem metallischen Material eines ersten Typs; Beschichten einer jeden der Schablonen-Nanostrukturen mit einem Beschichtungsmetall (58) eines zweiten Metallmaterialtyps, um Nanostrukturen (66) mit beschichteter Schablone zu bilden; Ätzen der Schablonen-Nanostrukturen, um hohle Nanostrukturen (66) aus dem Beschichtungsmetall zu bilden; und Ablagern der hohlen Nanostrukturen auf einem Substrat, um ein leitfähiges Netzwerk (78) zu bilden, wobei das leitfähige Netzwerk ein Kontrastverhältnis von höher als 1000 hat.

11. Verfahren nach Anspruch 10, welches ferner nach dem Ablagern das Ausrichten im Wesentlichen sämtlicher der hohlen Nanostrukturen entlang ihrer jeweiligen Längsachsen umfasst,
wobei das Ablagern vorzugsweise das Ablagern und Orientieren einer ersten Population der hohlen Nanostrukturen entlang einer ersten Richtung und das Ablagern und Orientieren einer zweiten Population der hohlen Nanostrukturen entlang einer zweiten Richtung umfasst, wobei die erste Richtung und die zweite Richtung zueinander orthogonal sind.

12. Verfahren nach Anspruch 10, wobei die Beschichtung durch galvanische Beschichtung (electroplating), nichtgalvanische (electro-less) Beschichtung oder Metall-Metall-Ersetzung durchgeführt wird, oder
wobei das Ätzen elektrochemisch oder chemisch durchgeführt wird, oder
wobei die Beschichtung durch nichtgalvanische (electro-less) Beschichtung und das Ätzen chemisch in einer Lösungsphase durchgeführt wird.

13. Verfahren nach Anspruch 10, wobei die Anzeige oder das Touchscreen flexibel ist.

14. Verfahren nach Anspruch 10, wobei die Schablonen-Nanostrukturen anisotrope Nanostrukturen sind, wobei die hohle Nanostruktur vorzugsweise eine Wanddicke hat, die geringer ist als ein Durchmesser der Schablonen-Nanostruktur.

15. Verfahren nach Anspruch 14, wobei die Schablonen-Nanostrukturen metallische Nanodrähte sind, insbesondere Silber-Nanodrähte, vorzugsweise Silber-Nanodrähte, die einen Durchmesser von ungefähr 30 bis 80 nm haben, und das Beschichtungsmetall Gold, Palladium, Nickel, oder Platin ist, wobei die Nanoröhren vorzugsweise 10 bis 20 nm dick sind.

**Revendications**

1. Conducteur transparent (22) formant une électrode transparente dans un dispositif d'affichage ou un écran tactile, comprenant : un substrat (62) ; et un réseau conducteur (78) sur le substrat, le réseau conducteur (78) comprenant une pluralité de nanotubes métalliques (66) ou de nanofils composites (86), dans lequel chaque nanofil composite (86) comprend une nanostructure modèle (54) constituée d'un premier type de métal qui est plaqué avec un second type de métal (58) et dans lequel la nanostructure modèle du premier type de métal est oxydée au moins au niveau de sa surface,
dans lequel le conducteur transparent a un rapport de contraste supérieur à 1000.

**2.** Conducteur transparent (22) selon la revendication 1 dans lequel ledit dispositif d'affichage ou écran tactile est souple.

**3.** Conducteur transparent (22) selon la revendication 1 dans lequel le rapport de contraste est supérieur à 3000, de préférence supérieur à 5000.

**4.** Conducteur transparent (22) selon la revendication 1 ayant un facteur de transmission de la lumière supérieur à 85 %, de préférence supérieur à 90 % et de manière préférée entre toutes supérieur à 95 %.

**5.** Conducteur transparent (22) selon la revendication 1 ayant une résistivité de surface inférieure à 1000 $\Omega$/carré, de préférence inférieure à 500 $\Omega$/carré et de manière préférée entre toutes inférieure à 100 $\Omega$/carré.

**6.** Conducteur transparent (22) selon la revendication 1, dans lequel le conducteur transparent a un voile inférieur à 5 %, de préférence inférieur à 1 %.

**7.** Conducteur transparent (22) selon la revendication 1, dans lequel les nanotubes métalliques sont des nanotubes d'or.

**8.** Conducteur transparent (22) selon la revendication 1, dans lequel les nanotubes métalliques sont des nanotubes d'alliage ou bimétalliques, en particulier des nanotubes d'alliage or/argent ou bimétalliques.

**9.** Conducteur transparent (22) selon la revendication 1, comprenant en outre une surcouche sur le réseau conducteur.

**10.** Procédé de formation d'une électrode transparente d'un dispositif d'affichage ou d'un écran tactile, comprenant :
la formation de nanostructures modèles (54) d'un premier type de matériau métallique ; le placage de chacune des nanostructures modèles avec un métal de placage (58) d'un second type de matériau métallique pour former des nanostructures modèles plaquées (66) ; la gravure des nanostructures modèles pour former des nanostructures creuses (66) du métal de placage ; et le dépôt des nanostructures creuses sur un substrat pour former un réseau conducteur (78), dans lequel le réseau conducteur a un rapport de contraste supérieur à 1000.

**11.** Procédé selon la revendication 10 comprenant en outre, après le dépôt, l'alignement de la quasi-totalité des nanostructures creuses le long de leurs axes longitudinaux respectifs,
dans lequel le dépôt comprend de préférence le dépôt et l'orientation d'une première population des nanostructures creuses suivant une première direction, et le dépôt et l'orientation d'une seconde population des nanostructures creuses suivant une seconde direction, la première direction et la seconde direction étant perpendiculaires entre elles.

**12.** Procédé selon la revendication 10, dans lequel le placage est effectué par électroplacage, dépôt autocatalytique ou déplacement métal sur métal, ou
dans lequel la gravure est effectuée par voie électrochimique ou par voie chimique, ou dans lequel le placage est effectué par dépôt autocatalytique et la gravure est effectuée par voie chimique dans une phase de solution.

**13.** Procédé selon la revendication 10, dans lequel ledit dispositif d'affichage ou écran tactile est souple.

**14.** Procédé selon la revendication 10, dans lequel les nanostructures modèles sont des nanostructures anisotropes, dans lequel la nanostructure creuse a de préférence une épaisseur de paroi qui est inférieure à un diamètre de la nanostructure modèle.

**15.** Procédé selon la revendication 14, dans lequel les nanostructures modèles sont des nanofils métalliques, en particulier des nanofils d'argent, de préférence des nanofils d'argent d'environ 30 à 80 nm de diamètre, et le métal de placage est l'or, le palladium, le nickel ou le platine, dans lequel les nanotubes ont de préférence une épaisseur de 10 à 20 nm.

FIG. 1A          FIG. 1B

FIG. 2

FIG. 4

FIG. 3A

FIG. 3B

FIG. 3C

FIG. 5

**FIG. 6A**

**FIG. 6B**

**FIG. 7**

*200*

*100*

plating

*210*

*200*

*100*

pyrrole
polymerization

*220*

*210*

*200*

*100*

FIG. 8

*FIG. 9*

*FIG. 10*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 504822 A
- US 871767 A
- US 871721 A
- WO 20070222682 A
- US 2006257638 A
- US 20050056118 A1
- US 11871767 B
- US 11871721 B
- US 766552 A
- US 11504822 B
- US 815627 P

**Non-patent literature cited in the description**

- **ZHU J.** *Material Science and Engineering A,* 2007, 454-455
- **Y. SUN ; B. GATES ; B. MAYERS ; Y. XIA.** Crystalline silver nanowires by soft solution processing. *Nanolett,* 2002, vol. 2 (2), 165-168